# EUROPÄISCHE PATENTSCHRIFT

(11) **EP 3 961 077 B1**
(45) Veröffentlichungstag und Bekanntmachung des Hinweises auf die Patenterteilung: **27.09.2023**
(21) Anmeldenummer: 20193135.9
(22) Anmeldetag: 27.08.2020
(51) Int. Cl.: F16L 19/028, B60T 17/04, F02M 55/00, F16L 19/02

(54) **VERFAHREN ZUR BEHANDLUNG EINER ROHRLEITUNG, ROHRLEITUNG UND ROHRANSCHLUSSEINRICHTUNG**
PIPE, METHOD FOR TREATING A PIPE, AND PIPE CONNECTION DEVICE
PROCÉDÉ DE TRAITEMENT D'UNE CONDUITE, CONDUITE ET DISPOSITIF DE RACCORDEMENT DE CONDUITE

(43) Veröffentlichungstag der Anmeldung: 02.03.2022
(73) Patentinhaber: TI Automotive (Heidelberg) GmbH, 69123 Heidelberg (DE)
(72) Erfinder: Stahn, Andreas, 69231 Rauenberg (DE); Weick, Georg, 68723 Plankstadt (DE)
(74) Vertreter: Andrejewski - Honke Patent- und Rechtsanwälte Partnerschaft mbB

(56) Entgegenhaltungen:
- EP-A1- 2 860 433
- WO-A1-2016/116558
- DE-A1- 4 116 540
- DE-A1- 19 947 258
- DE-A1-102007 012 666
- DE-A1-102010 028 262
- DE-A1-102016 210 887
- DE-C1- 3 801 703
- DE-U1-202017 104 112

## Beschreibung

Die Erfindung betrifft ein Verfahren zur Behandlung einer Rohrleitung, insbesondere einer Kraftfahrzeug-Rohrleitung, wobei an zumindest einem Rohrleitungsende der Rohrleitung ein Bördel erzeugt wird. Die Erfindung betrifft weiterhin eine entsprechende Rohrleitung und eine Rohranschlusseinrichtung für den Anschluss einer solchen Rohrleitung. Bei dem Bördel der Rohrleitung kann es sich insbesondere um einen F-Bördel oder um einen E-Bördel handeln.

Derartige Rohrleitungen mit endseitigem Bördel werden insbesondere als Kraftfahrzeug-Rohrleitungen an einem Anschlusselement bzw. an einem Anschlussblock angeschlossen. Die Rohrleitungen werden beispielsweise für Hydraulikflüssigkeiten bzw. Bremsflüssigkeiten eingesetzt. Für den Anschluss an das Anschlusselement durchgreift die Rohrleitung in der Regel eine Axialbohrung eines Schraubfittings und das Stirnende des Schraubfittings wirkt auf die Rückseite des Bördels der Rohrleitung ein. Der Schraubfitting weist ein Außengewinde auf und wird für den Anschluss an das Anschlusselement in ein entsprechendes Innengewinde eingeschraubt. Beim Festschrauben des Schraubfittings wird die Bördelvorderseite der Rohrleitung normalerweise an eine Dichtfläche des Anschlusselementes angedrückt. In dem Anschlusselement ist in der Regel eine weitere Rohrleitung integriert, die mit der angeschlossenen Rohrleitung fluchtet. Beim Verschrauben der Schraubfittings kann es zu einem Mitdrehen der Rohrleitung kommen und durch eine Torsion der Rohrleitung wird Federkraft gleichsam in der Rohrleitung gespeichert. Die Torsion der Rohrleitung erzeugt ein Rückdrehmoment, das im Betrieb zu einem unerwünschten bzw. unkontrollierten Lockern bzw. Lösen der Schraubverbindung führen kann. Ein solches unerwünschtes Lockern der Schraubverbindung kann insbesondere auch durch Vibrationen entstehen, die beispielsweise im Motorraum von Kraftfahrzeugen auftreten.

Verfahren, Rohrleitungen und Rohranschlusselemente der eingangs beschriebenen Art sind aus der Praxis in unterschiedlichen Ausgestaltungen bekannt. Um die vorstehend beschriebenen Nachteile im Zusammenhang mit einer Torsion der Rohrleitung zu reduzieren, ist es bereits bekannt, den Bördel am Rohrleitungsende und insbesondere die Bördelrückseite - auf die das Stirnende des Schraubfittings einwirkt - entsprechend zu behandeln. So ist es bekannt (vgl. zum Beispiel Dokument WO 2016/116558 A1), vorher auf die Rohrleitung aufgebrachte Beschichtungen an dem Bördel zu entfernen und den Bördel an den betreffenden Flächen zu polieren, um die Reibungseigenschaften entsprechend zu beeinflussen. Dadurch soll erreicht werden, dass die Reibung zwischen dem einwirkenden Stirnende des Schraubfittings und der Bördelrückseite vermindert wird. - Diese bekannten Maßnahmen weisen aber eine Reihe von Nachteilen auf. Zum einen sind die Maßnahmen aufgrund der Mehrzahl von Verfahrensschritten relativ aufwendig und somit kostspielig. Zum anderen führt die Beseitigung von Beschichtungen zu unerwünschten Korrosionseffekten. Außerdem hängt die Qualität der bearbeiteten Oberfläche von einer Vielzahl von Parametern ab und die Oberflächen sind somit nicht reproduzierbar einstellbar bzw. einrichtbar. Somit ist die Funktionssicherheit der Schraubverbindungen nicht immer gewährleistet. Von daher besteht Verbesserungsbedarf.

Das Dokument DE 10 2010 028262 A1, das von der Carl Zeiss SMT GmbH stammt, offenbart eine Rohrleitung mit einem flanschartigen Enden, das mittels Plasmabeschichtung beschichtet wird.

Demgegenüber liegt der Erfindung das technische Problem zugrunde, ein Verfahren der eingangs genannten Art anzugeben, mit dem die vorstehend beschriebenen Nachteile einfach und effektiv vermieden werden können. Der Erfindung liegt weiterhin das technische Problem zugrunde, eine entsprechende Rohrleitung und eine entsprechende Rohranschlusseinrichtung anzugeben.

Zur Lösung dieses technischen Problems lehrt die Erfindung ein Verfahren 2. nach Anspruch 1 zur Behandlung einer Rohrleitung - insbesondere einer Kraftfahrzeug-Rohrleitung - , wobei an zumindest einem Rohrleitungsende der Rohrleitung ein Bördel erzeugt wird, wobei der Bördel zumindest bereichsweise mit zumindest einer Schicht versehen wird, die die Reibungseigenschaften der beschichteten Oberfläche des Bördels verändert und wobei die Beschichtung des Bördels mittels Plasmabeschichtung erfolgt. Der Bördel ist zweckmäßigerweise einstückig an dem Rohrleitungsende an die Rohrleitung angeformt bzw. wird aus der Rohrleitung geformt.

Die der Rohrleitung zugewandte Bördelrückseite wird zumindest bereichsweise durch Plasmabeschichtung mit einer Schicht bzw. mit einer ersten Schicht versehen, wobei diese Schicht bzw. erste Schicht einen Reibwert µ1 aufweist. Zweckmäßigerweise werden zumindest 50 %, insbesondere zumindest 60 % der Fläche der Bördelrückseite mit der Schicht bzw. ersten Schicht mittels Plasmabeschichtung versehen. Es liegt weiterhin im Rahmen der Erfindung, dass diese durch Plasmabeschichtung aufgebrachte Schicht bzw. erste Schicht einen geringen Reibwert bzw. einen sehr geringen Reibwert aufweist. Dadurch kann gewährleistet werden, dass beim Anziehen bzw. Festschrauben eines mit seinem Stirnende auf die Bördelrückseite einwirkenden Schraubfittings eine Torsion der Rohrleitung vermieden werden kann bzw. weitgehend vermieden werden kann. Zweckmäßigerweise wird bei einer solchen Ausführungsform mit einem Schraubfitting auch das Stirnende des Schraubfittings mit einer Schicht mit geringem Reibwert versehen, wobei diese Schicht ebenfalls bevorzugt durch Plasmabeschichtung aufgebracht werden kann. Gemäß einer bevorzugten Ausführungsform der Erfindung wird bei der Ausführungsform mit einem Schraubfitting auch das Gewinde bzw. Außengewinde des Schraubfittings beschichtet und zwar bevorzugt mit einer Schicht mit einem höheren Reibwert bzw. mit einem Reibwert, der höher ist als der Reibwert µ1 der Schicht auf der Bördelrückseite. Vorzugsweise ist der Reibwert der Schicht auf dem Gewinde bzw. Außengewinde des Schraubfittings zumindest dreimal, insbesondere zumindest viermal und sehr bevorzugt zumindest fünfmal so groß wie der Reibwert µ1 der Schicht bzw. ersten Schicht auf der Bördelrückseite. Es liegt im Übrigen im Rahmen der Erfindung, dass auch die Schicht auf dem Gewinde bzw. Außengewinde des Schraubfittings mittels Plasmabeschichtung aufgebracht wird. Die Plasmabeschichtung hat sich beim Aufbringen der Beschichtungen mit unterschiedlichen Reibwerten besonders bewährt.

Der Erfindung liegt die Erkenntnis zugrunde, dass mit Hilfe der erfindungsgemäßen Plasmabeschichtung der Reibwert der Bördelrückseite sehr funktionssicher gezielt eingestellt werden kann und vor allem auch reproduzierbar eingestellt werden kann. Beschädigungen der Rohrleitung und eventuell auf der Rohrleitung vorhandener Beschichtungen können vollständig vermieden werden und somit treten auch keine - aus dem Stand der Technik bekannten - Korrosionserscheinungen auf. Das Aufbringen der Schicht mit geringem Reibwert durch Plasmabeschichtung ist vor allem auf sehr einfache und wenig aufwendige Weise möglich. Eine Mehrzahl von Verfahrensschritten und der damit verbundene Aufwand entfällt bei dem erfindungsgemäßen Verfahren.

Gemäß der Erfindung wird die der Rohrleitung abgewandte und ein Stirnende der Rohrleitung bildende Bördelvorderseite zumindest bereichsweise durch Plasmabeschichtung mit einer Schicht bzw. mit einer zweiten Schicht versehen und diese Schicht bzw. zweite Schicht weist einen Reibwert µ2 auf. Dieser Reibwert µ2 ist größer bzw. deutlich größer als der Reibwert µ1 der auf der Bördelrückseite aufgebrachten Schicht bzw. ersten Schicht. - Gemäß dem erfindungsgemäßen Verfahren wird eine erste Schicht mit einem Reibwert µ1 zumindest bereichsweise auf dem Bördel - insbesondere auf der Bördelrückseite - mittels Plasmabeschichtung aufgebracht und eine zweite Schicht mit einem Reibwert µ2 wird zumindest bereichsweise auf dem Bördel - insbesondere an der Bördelvorderseite - mittels Plasmabeschichtung aufgebracht. Der zweite Reibwert µ2 ist dabei größer als der erste Reibwert µ1. Zweckmäßigerweise ist der zweite Reibwert µ2 zumindest dreimal, insbesondere zumindest viermal und bevorzugt zumindest fünfmal größer als der erste Reibwert µ1, der vorzugsweise der Schicht an der Bördelrückseite zuzuordnen ist.

Gemäß empfohlener Ausführungsform der Erfindung handelt es sich bei dem Bördel an dem Rohrleitungsende um einen F-Bördel oder um einen E-Bördel. Ein F-Bördel ist im Rahmen der Erfindung besonders bevorzugt. - Zweckmäßigerweise wird eine Rohrleitung eingesetzt, die aus Metall bzw. im Wesentlichen aus Metall besteht. Es liegt im Rahmen der Erfindung, dass der Bördel - insbesondere der F-Bördel - einstückig an der Rohrleitung bzw. an dem Rohrleitungsende angeformt ist und ebenfalls aus Metall bzw. im Wesentlichen aus Metall besteht.

Es liegt im Rahmen der Erfindung, dass die durch Plasmabeschichtung zu beschichtende Oberfläche zunächst gereinigt wird und zwar vorzugsweise mittels eines Plasmastrahls gereinigt wird. Diese Ausführungsform hat sich im Rahmen der Erfindung besonders bewährt. Zweckmäßigerweise wird insbesondere die Bördelrückseite des Bördels der Rohrleitung mittels eines Plasmastrahls gereinigt, bevor die Schicht mit dem Reibwert µ1 mittels Plasmabeschichtung auf diese Bördelrückseite bzw. auf die Oberfläche der Bördelrückseite aufgebracht wird.

Eine besonders empfohlene Ausführungsform des erfindungsgemäßen Verfahrens ist dadurch gekennzeichnet, dass die zumindest eine durch Plasmabeschichtung aufgebrachte Schicht aus zumindest einem Material bzw. aus zumindest einer Substanz aus der Gruppe "Metall; Metallsalz; Polymer" besteht bzw. im Wesentlichen besteht. Es empfiehlt sich, dass die auf die Oberfläche der Bördelrückseite aufzubringende Schicht aus zumindest einem Material aus der genannten Gruppe besteht bzw. im Wesentlichen besteht. Als Polymere kommen dabei insbesondere Fluorpolymere, Polyolefine und/oder Polyamide zum Einsatz. Empfohlenermaßen weist die mittels Plasmabeschichtung aufzubringende Schicht mit geringem Reibwert zumindest ein den Reibwert der Schicht erniedrigendes Gleitmittel auf und bei diesem Gleitmittel handelt es sich vorzugsweise um ein Fluorpolymer, insbesondere um Polytetrafluorethylen (PTFE) und/oder um Molybdändisulfid (MoS₂). Diese Schicht mit diesem Gleitmittel wird zweckmäßigerweise auf die Oberfläche der Bördelrückseite mittels Plasmabeschichtung aufgebracht. Grundsätzlich kann die mittels Plasmabeschichtung aufzubringende Schicht aus verschiedenen organischen und/oder metall-organischen Verbindungen und/oder Mischungen davon bestehen bzw. im Wesentlichen bestehen.

Es liegt im Rahmen der Erfindung, dass die Plasmabeschichtung bei Normaldruck bzw. bei Atmosphärendruck durchgeführt wird. Grundsätzlich kann die Plasmabeschichtung auch bei anderen Drücken, beispielsweise im Vakuum erfolgen. Die Plasmabeschichtung bei Normaldruck wird aber bevorzugt. Zweckmäßigerweise wird die Plasmabeschichtung als physikalische Gasphasenabscheidung und/oder als chemische Gasphasenabscheidung durchgeführt.

Es liegt im Rahmen der Erfindung, dass für die Plasmabeschichtung eine Plasmabeschichtungs-Vorrichtung eingesetzt wird und dass das Material für die Beschichtung der Plasmabeschichtungs-Vorrichtung pulverförmig zugeführt wird. Zweckmäßigerweise wird das Material für die Beschichtung in der Plasmabeschichtungs-Vorrichtung in die Gasphase überführt und anschließend in fester Form zumindest bereichsweise auf dem Bördel der Rohrleitung - insbesondere auf der Bördelrückseite der Rohrleitung - abgeschieden.

Zur Lösung des technischen Problems lehrt die Erfindung weiterhin eine Rohrleitung nach Anspruch 9, vorzugsweise eine Kraftfahrzeug-Rohrleitung, wobei an zumindest einem Rohrleitungsende der Rohrleitung ein Bördel vorhanden ist und wobei der Bördel zumindest bereichsweise mit zumindest einer mittels Plasmabeschichtung aufgebrachten Schicht versehen ist. Nach der Erfindung ist die Bördelrückseite zumindest bereichsweise mit zumindest einer mittels Plasmabeschichtung aufgebrachten Schicht versehen, wobei diese Schicht einen niedrigen bzw. einen sehr niedrigen Reibwert aufweist.

Zur Lösung des technischen Problems lehrt die Erfindung fernerhin eine Rohranschlusseinrichtung nach Anspruch 10 für den Anschluss von Rohrleitungen, insbesondere von Kraftfahrzeug-Rohrleitungen, mit zumindest einer Rohrleitung und mit zumindest einem Schraubelement, insbesondere einem Schraubfitting, wobei das Schraubelement mit zumindest einer seiner Oberflächen mit einer plasmabeschichteten Bördeloberfläche in Kontakt steht. Vorzugsweise steht das Schraubelement bzw. der Schraubfitting mit der plasmabeschichteten Bördelrückseite in Kontakt. Es liegt im Rahmen der Erfindung, dass das Schraubelement bzw. der Schraubfitting zumindest bereichsweise eine Beschichtung aufweist, insbesondere eine Beschichtung des Gewindes bzw. Außengewindes aufweist und dass der Reibwert µ3 der Gewindebeschichtung höher ist und bevorzugt wesentlich höher ist als der Reibwert µ1 der durch Plasmabeschichtung aufgebrachten Schicht an der Bördelrückseite des Bördels der Rohrleitung. Zweckmäßigerweise ist der Reibwert µ3 der Gewindebeschichtung mindestens doppelt so groß, insbesondere mindestens dreimal so hoch, bevorzugt mindestens viermal so hoch und sehr bevorzugt mindestens fünfmal so hoch wie der Reibwert µ1 der durch Plasmabeschichtung aufgebrachten Schicht an der Bördelrückseite des Bördels.

Der Erfindung liegt die Erkenntnis zugrunde, dass der Bördel der Rohrleitung, insbesondere die Bördelrückseite des Bördels, mittels der Plasmabeschichtung auf besonders einfache und wenig aufwendige Weise beschichtet werden kann und dass dabei zugleich ein definierter Reibwert der Schicht reproduzierbar eingestellt werden kann. Nachteilhafte Beschädigungen der Bördeloberfläche bzw. der Rohroberfläche treten dabei nicht auf. Das führt dazu, dass Korrosionserscheinungen im Gegensatz zu den aus dem Stand der Technik bekannten Maßnahmen vermieden werden können. Bei dem erfindungsgemäßen Verfahren sind deutlich weniger Verfahrensschritte erforderlich als bei den aus dem Stand der Technik bzw. aus der Praxis bekannten Maßnahmen. Insoweit ist die Herstellungszeit für die erfindungsgemäßen Rohrleitungen wesentlich geringer und die Herstellung weniger aufwendig und weniger kostspielig. Man erhält eine optimale Oberflächenqualität des beschichteten Bördels und diese Oberflächenqualität kann auch reproduzierbar erzeugt werden. Insgesamt zeichnet sich die Erfindung durch Einfachheit, geringen Aufwand und geringe Kosten aus. Hervorzuheben ist, dass mit den erfindungsgemäß beschichteten Bördeln nachteilhafte Torsionen der Rohrleitung sehr effektiv vermieden werden können und somit störende Rückdrehmomente der Rohrleitungen quasi nicht auftreten.

Nachfolgend wird die Erfindung anhand einer lediglich ein Ausführungsbeispiel darstellenden Zeichnung näher erläutert. Es zeigen in schematischer Darstellung:
- Fig. 1: eine erfindungsgemäße Rohrleitung mit erfindungsgemäß beschichtetem Bördel im Schnitt,
- Fig. 2: eine Rohranschlusseinrichtung mit dem Gegenstand gemäß Fig. 1 im Schnitt und
- Fig. 3: eine schematische Darstellung einer für das erfindungsgemäße Verfahren geeigneten Plasmabeschichtungs-Vorrichtung.

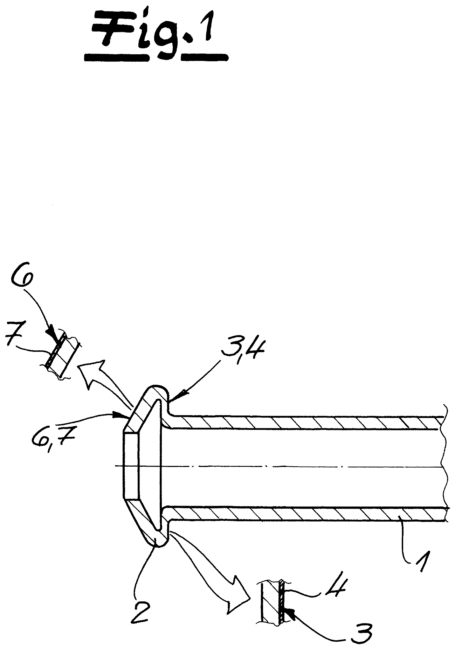

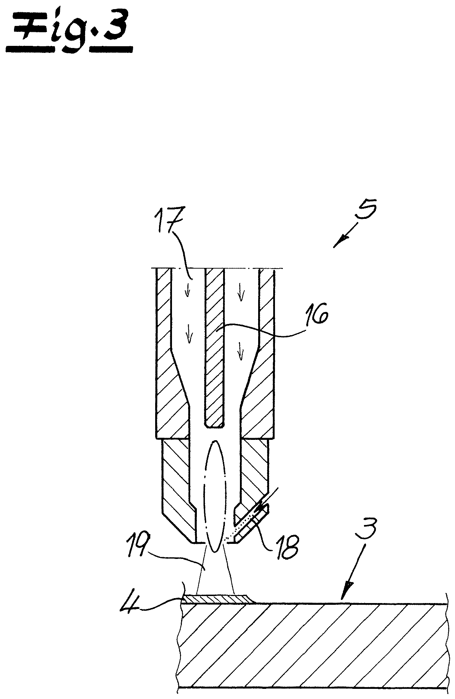

Die Fig. 1 zeigt eine nach dem erfindungsgemäßen Verfahren behandelte erfindungsgemäße Rohrleitung 1. Bei der Rohrleitung 1 handelt es sich nach bevorzugter Ausführungsform und im Ausführungsbeispiel um eine Kraftfahrzeug-Rohrleitung. An einem Rohrleitungsende dieser Rohrleitung 1 ist ein Bördel 2 vorhanden, der bevorzugt und im Ausführungsbeispiel als F-Bördel ausgebildet ist. Der Bördel 2 ist nach besonders empfohlener Ausführungsform und im Ausführungsbeispiel an seiner Bördelrückseite 3 mit einer ersten Schicht 4 versehen, die bevorzugt einen geringen Reibwert µ1 aufweist. Die an der Bördelrückseite 3 vorhandene Schicht wurde erfindungsgemäß durch Plasmabeschichtung aufgebracht und zwar bevorzugt mit einer in Fig. 3 dargestellten Plasmabeschichtungs-Vorrichtung 5.

Im Ausführungsbeispiel gemäß Fig. 1 ist die ein Stirnende der Rohrleitung 1 bildende Bördelvorderseite 6 mit einer zweiten Schicht 7 versehen, die einen Reibwert µ2 aufweist. Auch diese zweite Schicht 7 wird zweckmäßigerweise mit Hilfe einer Plasmabeschichtung aufgebracht. Es liegt im Rahmen der Erfindung, dass der Reibwert µ2 dieser zweiten Schicht 7 größer ist und bevorzugt wesentlich größer ist als der Reibwert µ1 der ersten Schicht auf der Bördelrückseite 3. Der Reibwert µ2 mag im Ausführungsbeispiel dreimal so groß sein wie der Reibwert µ1. - Die Rohrleitung 1 besteht zweckmäßigerweise aus Metall und der Bördel 2 bzw. F-Bördel besteht ebenfalls aus Metall und ist bevorzugt einstückig an die Rohrleitung 1 angeformt.

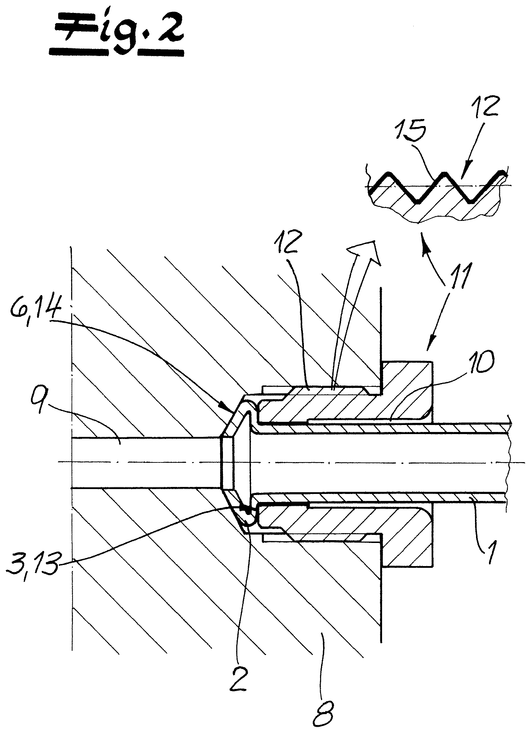

Die Fig. 2 zeigt ein Ausführungsbeispiel einer erfindungsgemäßen Rohranschlusseinrichtung mit einer angeschlossenen Rohrleitung 1 gemäß Fig. 1. Die Rohrleitung 1 ist bevorzugt und im Ausführungsbeispiel nach Fig. 2 an ein Anschlusselement bzw. an einen Anschlussblock 8 angeschlossen, wobei dieser Anschlussblock 8 zweckmäßigerweise und im Ausführungsbeispiel eine integrierte zweite Rohrleitung 9 aufweist. Die Rohrleitung 1 durchfasst bevorzugt und im Ausführungsbeispiel eine Axialbohrung 10 eines Schraubfittings 11, wobei dieser Schraubfitting 11 ein Außengewinde 12 aufweist. Im Ausführungsbeispiel nach Fig. 2 ist der Schraubfitting 11 mit seinem Außengewinde 12 in ein entsprechendes Komplementär-Innengewinde eingeschraubt. In diesem eingeschraubten Zustand wirkt das Stirnende 13 des Schraubfittings 11 auf die Bördelrückseite 3 des Bördels 2 ein. Der Schraubfitting 11 drückt den Bördel 2 bzw. die Bördelvorderseite 6 an eine Dichtfläche 14 des Anschlussblocks 8 an.

Durch die erste Schicht 4 auf der Bördelrückseite 3 mit dem geringen Reibwert µ1 wird die Reibung zwischen dem Stirnende 13 des Schraubfittings 11 und der Bördelrückseite 3 vermindert und auf diese Weise kann effektiv eine Torsion der Rohrleitung 1 verhindert werden. Der Erfindung liegt die Erkenntnis zugrunde, dass hier die Beschichtung der Bördelrückseite 3 mit der ersten Schicht 4 mittels Plasmabeschichtung zu ganz besonders vorteilhaften Resultaten führt. - Nach einer Ausführungsform und im Ausführungsbeispiel gemäß Fig. 2 weist das Außengewinde 12 des Schraubfittings 11 eine dritte Schicht 15 auf, die einen Reibwert µ3 aufweist. Dieser Reibwert µ3 der dritten Schicht 15 ist bevorzugt und im Ausführungsbeispiel größer und besonders bevorzugt deutlich größer als der Reibwert µ1 der ersten Schicht 4 an der Bördelrückseite 3. Der Reibwert µ3 der Schicht 15 auf dem Außengewinde 12 des Schraubfittings 11 mag im Ausführungsbeispiel mindestens dreimal so groß sein wie der Reibwert µ1 der ersten Schicht auf der Bördelrückseite 3. Es liegt im Übrigen auch im Rahmen der Erfindung, dass das Stirnende 13 des Schraubfittings 11 mit einer Schicht versehen ist, die einen geringen Reibwert aufweist. Grundsätzlich kann es sich dabei um dieselbe Schicht handeln, die auch an der Bördelrückseite 3 aufgebracht ist. Es liegt weiterhin im Rahmen der Erfindung, dass die Beschichtung an dem Stirnende 13 des Schraubfittings 11 ebenfalls durch Plasmabeschichtung aufgebracht wird. Auch die dritte Schicht 15 auf dem Außengewinde 12 des Schraubfittings 11 mit dem hohen Reibwert µ3 kann grundsätzlich durch Plasmabeschichtung aufgetragen werden. Der Erfindung liegt die Erkenntnis zugrunde, dass bei Aufbringung der Schichten mittels Plasmabeschichtung der Reibwert der Schichten besonders gezielt und genau eingestellt werden kann.

Die Fig. 3 zeigt eine Plasmabeschichtungs-Vorrichtung 5, die vorzugsweise für die Durchführung des erfindungsgemäßen Verfahrens eingesetzt wird. In der Fig. 3 wird die Beschichtung der Bördelrückseite 3 mit der ersten Schicht 4 durch Plasmabeschichtung dargestellt. Die Plasmabeschichtungs-Vorrichtung 5 weist in an sich bekannter Weise eine Elektrode 16 auf sowie eine Gaszuführung 17. Im Übrigen ist ein Kanal 18 vorgesehen, durch den das Material für die Plasmabeschichtung vorzugsweise pulverförmig eingebracht wird. Dargestellt ist auch der Plasmastrahl 19 für die Beschichtung der Bördelrückseite 3.

## Patentansprüche

1. Verfahren zur Behandlung einer Rohrleitung (1), insbesondere einer Kraftfahrzeug-Rohrleitung, wobei an zumindest einem Rohrleitungsende der Rohrleitung (1) ein Bördel (2) erzeugt wird, wobei der Bördel (2) zumindest bereichsweise mit zumindest einer Schicht (4) versehen wird, die die Reibungseigenschaften der beschichteten Oberfläche des Bördels (2) verändert und wobei die Beschichtung des Bördels (2) mittels Plasmabeschichtung erfolgt, **dadurch gekennzeichnet,**
**dass** die der Rohrleitung (1) zugewandte Bördelrückseite (3) zumindest bereichsweise durch Plasmabeschichtung mit einer ersten Schicht (4) versehen wird und dass die erste Schicht (4) einen Reibwert µ1 aufweist,
**dass** die der Rohrleitung (1) abgewandte und ein Stirnende der Rohrleitung (1) bildende Bördelvorderseite (6) zumindest bereichsweise durch Plasmabeschichtung mit einer zweiten Schicht (7) versehen wird, dass diese zweite Schicht (7) einen Reibwert µ2 aufweist,
und **dass** der zweite Reibwert µ2 größer ist als der erste Reibwert µ1.

2. Verfahren nach Anspruch 1, **dadurch gekennzeichnet, dass** der Bördel (2) als F-Bördel oder als E-Bördel erzeugt wird.

3. Verfahren nach einem der Ansprüche 1 oder 2, **dadurch gekennzeichnet, dass** eine Rohrleitung (1) eingesetzt wird, die aus Metall bzw. im Wesentlichen aus Metall besteht.

4. Verfahren nach einem der Ansprüche 1 bis 3, **dadurch gekennzeichnet, dass** die zumindest eine durch Plasmabeschichtung aufgebrachte Schicht (4, 7) aus zumindest einem Material aus der Gruppe "Metall; Metallsalz; Polymer, insbesondere Fluorpolymer" besteht bzw. im Wesentlichen besteht.

5. Verfahren nach einem der Ansprüche 1 bis 4, **dadurch gekennzeichnet, dass** die Plasmabeschichtung bei Normaldruck bzw. bei Atmosphärendruck durchgeführt wird.

6. Verfahren nach einem der Ansprüche 1 bis 5, **dadurch gekennzeichnet, dass** die Plasmabeschichtung als physikalische Gasphasenabscheidung und/oder als chemische Gasphasenabscheidung durchgeführt wird.

7. Verfahren nach einem der Ansprüche 1 bis 6, **dadurch gekennzeichnet, dass** für die Plasmabeschichtung eine Plasmabeschichtungs-Vorrichtung (5) eingesetzt wird und dass das Material für die Beschichtung der Plasmabeschichtungs-Vorrichtung (5) pulverförmig zugeführt wird.

8. Verfahren nach einem der Ansprüche 1 bis 7, **dadurch gekennzeichnet, dass** das Material für die Beschichtung in der Plasmabeschichtungs-Vorrichtung (5) in die Gasphase überführt wird und anschließend in fester Form zumindest bereichsweise auf dem Bördel (2) der Rohrleitung (1) abgeschieden wird.

9. Rohrleitung, vorzugsweise Kraftfahrzeug-Rohrleitung, behandelt nach einem der Ansprüche 1 bis 8.

10. Rohranschlusseinrichtung für den Anschluss von Rohrleitungen (1), insbesondere von Kraftfahrzeug-Rohrleitungen, mit zumindest einer Rohrleitung nach Anspruch 9 und mit zumindest einem Schraubelement, insbesondere einem Schraubfitting (11), wobei das Schraubelement mit zumindest einer Oberfläche mit einer plasmabeschichteten Bördeloberfläche in Kontakt steht.

11. Rohranschlusseinrichtung nach Anspruch 10, wobei das Schraubelement mit der plasmabeschichteten Bördelrückseite (3) in Kontakt steht.

12. Rohranschlusseinrichtung nach einem der Ansprüche 10 oder 11, wobei das Schraubelement zumindest bereichsweise eine Beschichtung aufweist, insbesondere eine Gewindebeschichtung aufweist und wobei der Reibwert µ3 der Gewindebeschichtung höher ist als der Reibwert µ1 der durch Plasmabeschichtung aufgebrachten Schicht (4) an der Bördelrückseite (3).

## Claims

1. A method for treating a pipe (1), in particular a motor vehicle pipe, wherein a flare (2) is generated at least at one pipe end of the pipe (1), wherein at least areas of the flare (2) are provided with at least one layer (4), which changes the friction properties of the coated surface of the flare (2), and wherein the flare (2) is coated by means of plasma coating, **characterized in that**
at least areas of the rear flare side (3) facing the pipe (1) are provided with a first layer (4) via plasma coating, and that the first layer (4) has a friction coefficient µ1,
at least areas of the front flare side (6) facing away from the pipe (1) and forming a front end of the pipe (1) are provided with a second layer (7) via plasma coating, and that this second layer (7) has a friction coefficient µ2,
and that the second friction coefficient µ2 is greater than the first friction coefficient µ1.

2. The method according to claim 1, **characterized in that** the flare (2) is generated as an F-flare or as an E-flare.

3. The method according to one of claims 1 or 2, **characterized in that** use is made of a pipe (1) consisting of metal or essentially of metal.

4. The method according to one of claims 1 to 3, **characterized in that** the at least one layer (4, 7) applied via plasma coating consists or essentially consists of at least one material from the group "metal; metal salt; polymer, in particular fluoropolymer".

5. The method according to one of claims 1 to 4, **characterized in that** plasma coating is performed at a normal pressure or atmospheric pressure.

6. The method according to one of claims 1 to 5, **characterized in that** plasma coating is performed via physical vapor deposition and/or chemical vapor deposition.

7. The method according to one of claims 1 to 6, **characterized in that** a plasma coating device (5) is used for plasma coating, and that the material for coating via the plasma coating device (5) is supplied in powder form.

8. The method according to one of claims 1 to 7, **characterized in that** the material for coating in the plasma coating device (5) is converted into the gas phase, and then deposited in solid form on at least areas of the flare (2) of the pipe (1).

9. A pipe, preferably a motor vehicle pipe, treated according to one of claims 1 to 8.

10. A pipe connection device for connecting pipes (1), in particular motor vehicle pipes, with at least one pipe according to claim 9, and with at least one screw element, in particular a screw fitting (11), wherein the screw element is in contact with at least one surface with a plasma-coated flare surface.

11. The pipe connection device according to claim 10, wherein the screw element is in contact with the plasma-coated rear flare side (3).

12. The pipe connection device according to one of claims 10 or 11, wherein at least areas of the screw element have a coating, in particular a thread coating, and wherein the friction coefficient µ3 of the thread coating is higher than the friction coefficient µ1 of the layer (4) applied via plasma coating on the rear flare side (3).

## Revendications

1. Procédé de traitement d'un tuyau (1), en particulier d'un tuyau pour le secteur automobile, sachant qu'un rebord (2) est produit sur au moins une extrémité de tuyau du tuyau (1), sachant que le rebord (2) est doté au moins par endroits d'au moins une couche (4), qui modifie les propriétés de frottement de la surface revêtue du rebord (2) et sachant que le revêtement du rebord (2) a lieu au moyen d'un revêtement au plasma, **caractérisé en ce que**
le revers de rebord (3) tourné vers le tuyau (1) est doté au moins par endroits d'une première couche (4) par revêtement au plasma et **en ce que** la première couche (4) comporte un coefficient de frottement µ1,
**en ce que** l'avant de rebord (6) distant du tuyau (1) et formant une extrémité frontale du tuyau (1) est doté au moins par endroits d'une deuxième couche (7) par revêtement au plasma, **en ce que** cette deuxième couche (7) comporte un coefficient de frottement µ2,
et **en ce que** le deuxième coefficient de frottement µ2 est supérieur au premier coefficient de frottement µ1.

2. Procédé selon la revendication 1, **caractérisé en ce que** le rebord (2) est produit sous la forme d'un rebord F ou sous la forme d'un rebord E.

3. Procédé selon l'une quelconque des revendications 1 ou 2, **caractérisé en ce qu'**un tuyau (1) est inséré, qui est composé de métal ou bien pour l'essentiel de métal.

4. Procédé selon l'une quelconque des revendications 1 à 3, **caractérisé en ce qu'**au moins une couche (4, 7) appliquée par revêtement au plasma est composée ou est composée pour l'essentiel d'au moins un matériau du groupe « métal, sel métallique, polymère, en particulier fluoropolymère ».

5. Procédé selon l'une quelconque des revendications 1 à 4, **caractérisé en ce que** le revêtement au plasma est exécuté sous pression normal ou sous pression atmosphérique.

6. Procédé selon l'une quelconque des revendications 1 à 5, **caractérisé en ce que** le revêtement au plasma est exécuté en tant que déposition physique en phase gazeuse et/ou en tant que déposition chimique en phase gazeuse.

7. Procédé selon l'une quelconque des revendications 1 à 6, **caractérisé en ce qu'**un dispositif de revêtement au plasma (5) est utilisé pour le revêtement au plasma et **en ce que** le matériau pour le revêtement du dispositif de revêtement au plasma (5) est fourni sous forme pulvérulente.

8. Procédé selon l'une quelconque des revendications 1 à 7, **caractérisé en ce que** le matériau pour le revêtement du dispositif de revêtement au plasma (5) est transféré en phase gazeuse et ensuite au moins par endroits déposé en forme solide sur le rebord (2) du tuyau (1).

9. Tuyau, de préférence tuyau pour le secteur automobile, traité selon l'une quelconque des revendications 1 à 8.

10. Système de raccord de tuyau pour le raccordement de tuyaux (1), en particulier de tuyaux pour le secteur automobile, avec au moins un tuyau selon la revendication 9 et avec au moins un élément à visser, en particulier un raccord à visser (11), sachant que l'élément à visser est en contact avec au moins une surface avec une surface de rebord revêtue de plasma.

11. Système de raccord de tuyau selon la revendication 10, sachant que l'élément à visser est en contact avec le revers de rebord (3) revêtu de plasma.

12. Système de raccord de tuyau selon l'une quelconque des revendications 10 ou 11, sachant que l'élément à visser comporte au moins par endroits un revêtement, comporte en particulier un revêtement de filetage et sachant que le coefficient de frottement µ3 du revêtement fileté est supérieur au coefficient de frottement µ1 de la couche (4) appliquée par revêtement au plasma sur le revers de rebord (3).
